# EUROPEAN PATENT SPECIFICATION

(11) **EP 0 770 922 B1**
(45) Date of publication and mention of the grant of the patent: **28.08.2002**
(21) Application number: 95922752.1
(22) Date of filing: 23.06.1995
(51) Int. Cl.: G03F 7/00, G03F 7/40

(54) **METHOD OF REMOVING SURFACE STICKINESS OF RELIEF PRINTING PLATE MADE FROM PHOTOSENSITIVE RESIN**
VERFAHREN UM DIE OBERFLÄCHEN KLEBRIGKEIT EINER RELIEFDRUCKPLATTE AUS PHOTOHARZ ZU ELIMINIEREN
PROCEDE D'ELIMINATION DE L'ADHESIVITE DE SURFACE D'UNE PLAQUE D'IMPRESSION EN RELIEF EN RESINE PHOTOSENSIBLE

(30) Priority: 12.07.1994 JP 16007894
(43) Date of publication of application: 02.05.1997
(73) Proprietor: Asahi Kasei Kabushiki Kaisha, Osaka-shi, Osaka 530-8205 (JP)
(72) Inventor: DHEUR, André, B-4000 Liège (BE); TOMITA, Hiroaki, Shizuoka 416 (JP)
(74) Representative: Strehl Schübel-Hopf & Partner
(86) International application number: JP9501263
(87) International publication number: WO96002020

(56) References cited:
- JP-A- 1 121 858
- JP-A- 52 090 304
- JP-A- 56 060 441
- JP-A- 60 234 894
- JP-A- 61 120 142
- JP-A- 61 294 445
- US-A- 4 415 654
- US-A- 4 716 094
- PATENT ABSTRACTS OF JAPAN vol. 7, no. 202 (P-221), 7 September 1983 & JP 58 100128 A (TEIJIN KK)

## Description

### TECHNICAL FIELD

The present invention relates to a method for removing surface tack from a relief printing plate obtained from a liquid photosensitive resin.
Particularly, the present invention relates to a method for removing surface tack from a flexographic printing plate, which is used to print on corrugated board, films, paper bags or the like, stamping printing plates, or the like.

### BACKGROUND ART

In the field of flexographic printing such as corrugated board printing, film printing or the like, or for a stamping printing plate, a photosensitive resin relief printing plate has been used for a long time instead of a conventional rubber plate. In production of the photosensitive resin relief printing plate, a liquid photosensitive resin, which is in a liquid state before being exposed to light, is often used because of the reasons that 1. the liquid photosensitive resin is excellent in economic advantages because the resin in non-image parts, which does not make a relief, can be recovered and reused and 2. it provides a good working environment since the development can be done with an aqueous washout solution. A desired photosensitive resin relief printing plate is usually obtained from the liquid photosensitive resin process with a plate-making apparatus through an imagewise exposure process, a developing process, a post-exposure process and drying.

A printing plate having high surface tack is often obtained from the liquid photosensitive resin. The printing plate having high surface tack has a problem of decrease in workability because the plate adheres to the hands of workers when checking the plate finishing or in a galley proof operation to confirm printing quality, and because it is difficult to release the plates from each other owing to adhesion of plates when the plates are stacked.

In order to remove surface tack from a printing plate obtained using liquid photosensitive resin, there is known a method for applying actinic radiation to the plate, which is dipped in water to isolate the plate from air, in the above post-exposure process (a method of post-exposure in water). This method is used to fully harden parts, which are not sufficiently hardened in a imagewise exposure process. By this method, removal from the plate of surface tack caused by uncured resins is attempted. Although tack does decrease, the tack removal effect is not sufficient to solve the above problems.

A method for applying various types of coating agents, such as "SARAN" TM emulsion and talcum powder, on the surface of the printing plate have been attempted. Surface tack on the printing plate can be removed by this method. However, the quality of the plate image is deteriorated because the above coating agents enter and fill depressions such as reverse image portions of the relief printing plate.

There has been proposed a method for incorporating a specific compound into a liquid photosensitive resin composition (JP-B-5-55857). According to this method, surface tack on a plate can be removed without deteriorating the quality of the plate image. However, in order to remove tack sufficiently, a waiting period of more than several hours is necessary after the drying process in plate-making. Because of this, when an operation to check a plate or a galley proof operation is conducted immediately after drying, tack is not sufficiently removed.

The purpose of the present invention is to provide a method for removing surface tack from a plate immediately after the drying process when making a photosensitive resin relief printing plate by using a liquid photosensitive resin, without deteriorating the quality of the plate image.

### SUMMARY OF THE INVENTION

The present inventors have made intensive and extensive studies. As a result, they have found a solution to the above problems by applying to the surface of a relief printing plate having tack obtained from a liquid photosensitive resin by at least the steps of imagewise exposure, development and post exposure, an aqueous solution or an alcohol solution containing a compound represented by the following general formula (1):

R₁-X (1)

wherein R₁ represents a monovalent hydrocarbon group of CₙH₂ₙ₊₁ or CₙH₂ₙ₋₁ in which n is an integer of 11 or more, and X represents a hydroxyl group, a carboxyl group, an amide derivative or an alkali metal salt derivative of the carboxyl group,
wherein the method is carried out after the post exposure treatment.

The present invention will be described in detail below.

A liquid photosensitive resin used in the present invention is liquid at 25°C before being exposed to light. The liquid photosensitive resin becomes insoluble by exposing it to actinic radiation. The liquid photosensitive resin is a composition comprising a prepolymer, an ethylene type addition polymerizable monomer, a photopolymerization initiator and, if necessary, various types of additives.

Prepolymers include an unsaturated polyurethane and an unsaturated polyester. Unsaturated polyurethanes include a polyether polyester block polyurethane which has 2 or more terminal groups having an ethylenic double bond (JP-B-52-7761) and an unsaturated polyurethane containing at least one terminal polymerizable ethylenic double bond and hydrogenated 1,2-polybutadiene as a segment (JP-B-55-34930). Unsaturated polyesters include an unsaturated polyester obtained by condensation polymerization of a dibasic acid containing an unsaturated dibasic acid with a diol (JP-B-51-37320).

Ethylene type addition polymerizable monomers include unsaturated carboxylic acids such as acrylic acid and methacrylic acid, esters thereof, acrylamide, methacrylamide, derivatives thereof, an allyl compound, maleic acid, fumaric acid and esters thereof. The total amount of the ethylene type addition polymerizable monomers is usually 5 to 200 parts by weight based on 100 parts of the prepolymer.

As photopolymerization initiators, any type thereof can be selected from conventional compounds and used. They include benzophenone, benzoinisopropylether and 2,2-dimethoxy-2-phenylacetophenone. The amount is usually 0.01 to 10 % by weight based on the total amount of the prepolymer and the ethylene type addition polymerizable monomer.

According to application or purposes, a heat polymerization inhibitor, an ultraviolet light absorber, a light stabilizer, a dye, a pigment, a lubricant, an inorganic filler, a surfactant and the like can be added to the liquid photosensitive resin used in the present invention.

As a method for producing a photosensitive resin relief printing plate by using the above liquid photosensitive resin, there are known various methods. The photosensitive resin relief printing plate can be typically produced by conducting the following processes in order, that is, 1) a forming process which comprises putting a negative film on a glass plate capable of transmitting actinic radiation from a light source below, covering the negative film with a thin protective film, and while pouring a liquid photosensitive resin on the protective film, laminating a base film of a support on the poured liquid photosensitive resin so that the liquid photosensitive resin can have a constant thickness, 2) a back exposure process which comprises forming a uniform thin resin layer as an anchor layer on the entire area of the support side of the plate by conducting exposure for a short time from the support side with light source above, 3) an exposure process to form the relief which comprises conducting imagewise exposure through a transparent part of the negative film with a light source below, 4) a developing process to wash out and remove unhardened resin and 5) a post-exposure and drying process which comprises immersing the whole of the post-developed plate into water, sufficiently hardening any insufficiently hardened parts by conducting exposure to actinic radiation, and drying.

When a hardened plate has a thickness of 4 mm or more, a land area (shelf part) to be the base of the relief is often formed in advance by selectively conducting exposure (masking exposure) from the support side with a light source above before the exposure process to form the relief.

Actinic radiation sources used for exposure in a plate-making process include a high pressure mercury lamp, ultra-high pressure mercury lamp, an ultraviolet fluorescent lamp, a carbon arc lamp and a xenon lamp. Transparent image carriers used to form relief image include a negative film or a positive film used for silver salt-image photoengraving.

Washout solutions for unhardened resin include water, an alkaline aqueous solution and an aqueous solution containing a surfactant.

A photosensitive resin relief printing plate produced in the above manner often has high surface tack. In particular, a photosensitive resin relief printing plate obtained from a photosensitive resin which contains, as a prepolymer, an unsaturated polyurethane having hydrogenated 1, 2-polybutadiene as a segment and having at least one terminal polymerizable ethylenic double bond, tends to have high surface tack. Therefore, the method for removing surface tack of the present invention is remarkably effective. In practical use an acceptable surface tack of a photosensitive resin relief printing plate means that the stacked relief printing plates are easily released from each other.

The method for removing surface tack of the present invention will be described in detail below.

The method for removing surface tack of the present invention comprises applying an aqueous solution or an alcohol solution containing a compound represented by the general formula (1) on the tacky surface of a relief printing plate obtained from a liquid photosensitive resin, or dipping the surface of the relief printing plate into the aqueous solution or the alcohol solution and then taking it out.

In a compound represented by the general formula (1) (hereinafter referred to as Compound A), R₁ represents a monovalent hydrocarbon group of CₙH₂ₙ₊₁ or CₙH₂ₙ₋₁ in which n represents an integer of 11 or more, and X represents a hydroxyl group, a carboxyl group, an amide derivative or an alkali metal salt derivative of the carboxyl group.

When X is a hydroxyl group, a carboxyl group, an amide derivative or an alkali metal salt derivative of the carboxyl group, surface tack is sufficiently removed. In respect of effect to remove surface tack, the hydroxyl group and the carboxyl group are preferable. When X is the alkali metal salt derivative of the carboxyl group, Compound A can be used in combination with an aqueous type solvent because of its high solubility in water.

For R₁, in respect of effect to remove surface tack, n is 11 or more, preferably 11 to 30, more preferably 11 to 22. When n is less than 11, surface tack can not be sufficiently removed. When R₁ contains an unsaturated bond, Compound A becomes more hydrophilic. Thus, Compound A can be used in combination with an aqueous type solvent because of high solubility.

Representative examples of Compound A having a hydroxyl group include dodecyl alcohol, myristyl alcohol, pentadecyl alcohol, heptadecyl alcohol, stearyl alcohol, nonadecyl alcohol, arachidic alcohol and cetyl alcohol. Representative examples of Compound A having a carboxyl group include lauric acid, n-tridecyl acid, myristic acid, n-pentadecylenic acid, palmitic acid, stearic acid, elaidic acid, n-nonadecylenic acid, arachidic acid and isostearic acid. Representative examples of Compound A which is an amide of a carboxylic acid include lauric acid amide, myristic acid amide, palmitic acid amide, stearic acid amide and eicosanic acid amide. Representative examples of Compound A which is an alkali metal salt of a carboxylic acid include alkali metal salts of compound A having the above carboxyl group such as sodium stearate, potassium stearate, sodium oleate and potassium oleate. Compound A can be used alone or in combination.

A solution is prepared by dissolving the above Compound A in a solvent. The solvent is water or an alcohol which can dissolve Compound A. When water or the alcohol is used as a solvent, the photosensitive resin relief printing plate is hardly swollen and it is difficult to deteriorate its mechanical properties and damage the relief surface. Further, water and the alcohol have a merit that they are easy to handle under working environment conditions because they are generally of little harm to the human body.

Water includes an acid aqueous solution and an alkali aqueous solution. Representative examples of alcohols include monovalent alcohols, that is, methanol, ethanol, 1-propanol, 2-propanol, 1-butanol, 2-butanol and tert-pentylalcohol. In particular, water, methanol, ethanol, 1-propanol and 2-propanol are preferable. Representative examples of water or an alcohol solution containing Compound A (hereinafter referred to as a solution for removing surface tack) include an ethanol solution containing stearic acid amide, a 2-propanol solution containing cetyl alcohol, an aqueous solution containing sodium oleate.

The concentration of Compound A in the solution for removing surface tack is not particularly limited. When Compound A is used alone or in combination, the concentration of the total amount of Compound A is preferably 0.5 to 15 % by weight. When the concentration is lower than 0.5 % by weight, surface tack is not sufficiently removed. When the concentration is higher than 15 % by weight, the effect of removal of surface tack certainly increases. However, since Compound A becomes excessively attached to the solid relief surface, white mottling appears on the surface so that the finishing of the plate often becomes dirty.

Methods for applying the solution for removing surface tack include wiping the surface of a photosensitive resin relief printing plate with a cloth, a nonwoven fabric, a sponge, paper or a brush containing the solution, and spraying the surface of the photosensitive resin relief printing plate with the solution. Any requirement to repeat the application depends upon a concentration of the solution and the like. However, the effect of removal of surface tack is generally immediately obtained by applying once or several times and drying for 10 to 30 minutes. Therefore, the treated plate can be used in the next process step within 1 hour.

Methods for dipping the surface of a photosensitive resin relief printing plate into the solution to remove surface tack and then taking out it include dipping only the surface of the relief printing plate and then taking out it and dipping the whole of the relief printing plate including the surface and then taking out it. Dipping time depends on the concentration of the solution. However, the effect of removal of surface tack is generally immediately obtained by dipping for several seconds to several tens seconds and drying for 10 to 30 minutes. Therefore, the treated plate can be used within 1 hour.

According to the method for removing surface tack of the present invention, depressions such as reverse image portions of the relief printing plate are not filled with coating agents so that the quality of the plate image is not deteriorated. Further, the characteristic performance such as mechanical properties, ink resistance, receptivity and transferability which should be possessed by a photosensitive resin relief printing plate are not deteriorated.

The method for removing surface tack of the present invention can be generally used after a post-exposure process or drying process in a method for producing a photosensitive resin relief printing plate as mentioned above.

### BEST MODE FOR CARRYING OUT THE INVENTION

Hereinafter, the present invention will be described in more detail with reference to examples, which should not be construed as limiting the scope of the present invention.

Abbreviations of compounds used in the Examples and Comparative Examples are shown in Table 1.

Prepolymers A to C are prepared according to the following methods.

### (Preparation Example 1) Preparation of Prepolymer A

800 g of poly(propylene glycol adipate) diol (hydroxyl value: 44.88), 800 g of polyoxyethylene (EO)-oxypropylene (PO) block copolymer diol (molar ratio of EO to PO: 1/4, hydroxyl value: 44.88) and 0.32 g of dibutyltin dilaurate (BTL) as a catalyst were charged into a reaction vessel and mixed well. 130.5 g of tolylene diisocyanate (ratio of 2,4- tolylene diisocyanate to 2,6-tolylene diisocyanate: 1/4, hereinafter referred to as TDI) was added and stirred well. The temperature was raised from 40°C to 80°C and then reaction was carried out for about 5 hours. Next, 353.4 g of poly(oxypropyrene) glycol monomethacrylate (PPMA, number-average molecular weight: 380) was added and stirred well. Reaction was conducted for about 2 hours and stopped. Unsaturated polyurethane prepolymer A was obtained. Unsaturated polyurethane prepolymer A contained PPMA in an amount exceeding its stoichometric amount (hereinafter referred to as excess PPMA). The number-average molecular weight Mn of unsaturated polyurethane prepolymer A containing no excess PPMA was measured according to the following GPC method. It was about 2.3 X 10⁴.

### GPC method

The conditions to measure number-average molecular weight in terms of polystyrene by the GPC method are as follows.
- Column:: two polystyrene gel columns TSK GEL GMHXL (7.8 mm × 300 mm, manufactured by TOSOH CORPORATION)
- Solvent:: THF (does not contain any substantial quantity of water)
- Flow rate:: 1.0 ml/min.
- Sample concentration:: 0.4 to 0.5 %
- Calibration:: concentration is about one half of a sample concentration.
- Significant figure:: two digits
- Detector:: differential refractometer
- Standard polystyrene:: range of number-average molecular weight is 5.00 × 10² to 1.26 × 10⁶.
- GPC apparatus:: high-performance GPC HLC-8020 (manufacture by TOSOH CORPORATION)

### (Preparation Example 2) Preparation of Prepolymer B

220 g of hydrogenated 1,2- polybutadiene having an average of 1.7 terminal hydroxyl groups per molecule (number-average molecular weight: 2,200, hydrogenation rate: 87 %) and 22.2 g of TDI were mixed by stirring at 40°C for 30 min. and then reacted at 80°C for 5 hours. A solution of a mixture of 12 g of 2-hydroxyethylmethacrylate (HEMA), 0.3 g of 2,6-di-t-butyl-p-cresol and 0.6 g of BTL was added. The reaction was conducted at 80°C for about 2 hours and stopped. Unsaturated polyurethane prepolymer B was obtained. The number-average molecular weight Mn of unsaturated polyurethane prepolymer B containing no excess PPMA was measured according to the above GPC method. It was about 1.3 × 10⁴.

### (Preparation Example 3) Preparation of Prepolymer C

Unsaturated polyester prepolymer C was obtained by subjecting a mixture of 50 g of polyoxyethylene glycol (number-average molecular weight: 200), 15.5 g of ethylene glycol and 58 g of maleic acid to condensation polymerization at 180°C under reduced pressure in a nitrogen atmosphere for 6 hours. The number-average molecular weight Mn of unsaturated polyurethane prepolymer C containing no excess PPMA was measured according to the above GPC method. It was about 1.1 × 10⁴.

Liquid photosensitive resin compositions D to H shown in Tables 2 to 4 were prepared by adding ethylene type addition polymerizable monomers, photopolymerization initiators and other additives to Prepolymers A to C prepared in the above preparation examples.

Next, two patterns (Patterns I and II) each of photosensitive resin relief printing plates D(I), D(II) to H(I) and H(II) (D(I) denotes a photosensitive resin relief printing plate D having Pattern I prepared by using a liquid photosensitive resin produced according to the following method by using photosensitive resin D to H, and so on.)
Pattern I: total thickness of 3 mm, anchor layer thickness (including support thickness) of about 1 mm, solid image area 6 cm × 7 cm, anchor layer area 10 cm × 10 cm
Pattern II: total thickness of 3 mm, anchor layer thickness (including support thickness) of about 1 mm, screen tint image area (25.6 line/cm (65 line/inch), dot area ratio of 5 %) 4 cm × 3 cm, reverse fine line image (width 250µ × length 3 cm), anchor layer area 10 cm × 10 cm

As exposure apparatus, AF210E (manufactured by Asahi Chemical Industry Co., Ltd.) was used. In the case of liquid photosensitive resins D and E, in development, washing was conducted using AL400W (manufactured by Asahi Chemical Industry Co., Ltd.) apparatus and a 2 wt.% W-8 (manufactured by Asahi Chemical Industry Co., Ltd.) solution as aqueous developer at about 40°C for 6 min. In the case of liquid photosensitive resins F and G, in development, washing was conducted using ALF-200W (manufactured by Asahi Chemical Industry Co., Ltd.) apparatus and a 3 wt.% W-6 (manufactured by Asahi Chemical Industry Co., Ltd.) solution as a aqueous developer at about 40°C for 20 min. In the case of liquid photosensitive resin H, in development, washing was conducted using A-300W (manufactured by Asahi Chemical Industry Co., Ltd.) apparatus and a 1 wt.% W-1 (manufactured by Asahi Chemical Industry Co., Ltd.) solution as a aqueous developer at about 40°C for 6 min. Post-exposure was conducted by exposing to an ultraviolet fluorescent lamp and a germicidal lamp at the same time in water using ALF200UP (manufactured by Asahi Chemical Industry Co., Ltd.) apparatus for 10 min. Drying was conducted using AL100P (manufactured by Asahi Chemical Industry Co., Ltd.) apparatus at 60°C for 10 min.

Solutions 1 to 4 for removing surface tack shown in Table 5 were prepared in order to verify the effect of the present invention. The surfaces of photosensitive resin relief printing plates D(I) to H(II) obtained above were treated by using these solutions according to the following two methods α and β in Examples 1 to 5. The treatment was not conducted in Comparative Examples 1 to 5. Talcum powder was directly applied to the surface of a plate with a cotton cloth (cotton 100%, trade name: Bencott, manufactured by Asahi Chemical Industry Co., Ltd.) in Comparative Example 6.
(α) a cotton cloth (cotton 100%, trade name: Bencott, manufactured by Asahi Chemical Industry Co., Ltd.) was immersed in the solution for removing surface tack and then wrung well. The surface of one of the above photosensitive resin relief printing plates was wiped with the wrung cotton cloth 5 times and then was subjected to air-drying for 10 min.
(β) the whole of one of the above photosensitive resin relief printing plates was immersed in the solution to remove surface tack at 20°C for 30 seconds and then was taken out. Air-drying was conducted for 10 min.

Surface tack and the quality of plate image was evaluated according to the following methods in Examples 1 to 5 and Comparative Examples 1 to 6.

Surface tack: two printing plates having Pattern I were used. The first one was put on a flat surface so that the support of the base film faced down. The second one was stacked on top so that the base film surface of the second one faced down and contacted the reverse image surface of the first one already placed on the flat surface. A weight was put on the stacked printing plates so as to give a surface pressure of 20 g/cm² thereon. The weight was left at rest for 10 min, then weight was removed. The two stacked printing plates were lifted by pinching one corner of the upper one with fingers. Surface tack of the printing plate was evaluated by measuring the time period required until the lower one dropped due to its own weight after lifting the two stacked printing plates. The evaluation was conducted immediately after treatments α or β (in the case of no treatment, immediately after plate-making). The case where the time from lifting the stacked printing plates to the lower one dropping by own weight was within 10 seconds is recorded as ○. The case where the time was 10 seconds to 1 min. is recorded as Δ. The case where the lower plate did not drop by own weight was recorded as ×.

The quality of plate image (reverse image portions filled with coating agents): A printing plate having Pattern II was observed with a 10 X magnifier in order to examine whether Compound (A) enters and fills depressions of the screen tint image area and reverse fine line image. The case where depressions filled with Compound (A) were not observed was recorded as ○. The case where depressions filled with Compound (A) were observed was recorded as ×.

The results of evaluation of surface tack and the quality of print image in Examples and Comparative Examples are shown in Table 6.

As shown in Table 6, 10 min. after treatment with a solution for removing surface tack, surface tack was improved to such a level that the plates were evaluated as ○, and depressions filled with Compound (A) were not observed as a result of observation on plate image in Examples 1 to 5. On the contrary, after 10 min. from treatment with a solution for removing surface tack, surface tack was not improved to a level where plates were evaluated as ○ in Comparative Examples 1 to 5. In Comparative Example 6, 10 min. after treatment with talcum powder, surface tack was improved to such a level that plates were evaluated as ○. However, depressions filled with baby powder were observed as a result of observation of plate image.

### INDUSTRIAL APPLICABILITY

The present invention provides a method for removing surface tack by applying an aqueous solution or an alcohol solution containing a specific compound to the surface of relief printing plates having surface tack obtained from a liquid photosensitive resin or by dipping the surface of the relief printing plate into an aqueous solution or an alcoholic solution and then taking it out. According to the method for removing surface tack of the present invention, surface tack of a plate can be removed without deteriorating the quality of plate image immediately after the drying process when making a photosensitive resin relief printing plate by using a liquid photosensitive resin.

**Table 1**

| Abbreviation of compounds | |
|---|---|
| Abbreviation | Compound |
| HEMA | 2-hydroxyethyl methacrylate |
| PPMA | poly(oxypropyrene)glycol monomethacrylate (Mn=380) |
| LMA | laurylmethacrylate |
| TEGDMA | tetraethyleneglycol dimethacrylate |
| TMPTMA | trimethylolpropane trimethacrylate |
| PGDM | polypropyleneglycol dimethacrylate (Mn=660) |
| BGM | butanediol dimethacrylate |
| ACAC | acrylic acid |
| ACAM | acrylamide |
| ST | styrene |
| DMPAP | 2,2-dimethoxy-2-phenylacetophenone |
| BP | benzophenone |
| BIBE | benzoin isobutylether |
| BZ | benzoin |
| BHT | 2,6-di-t-butyl-p-cresol |
| HQ | hydroquinone |
| MLSA | myristic acid |
| CTAL | cetyl alcohol |

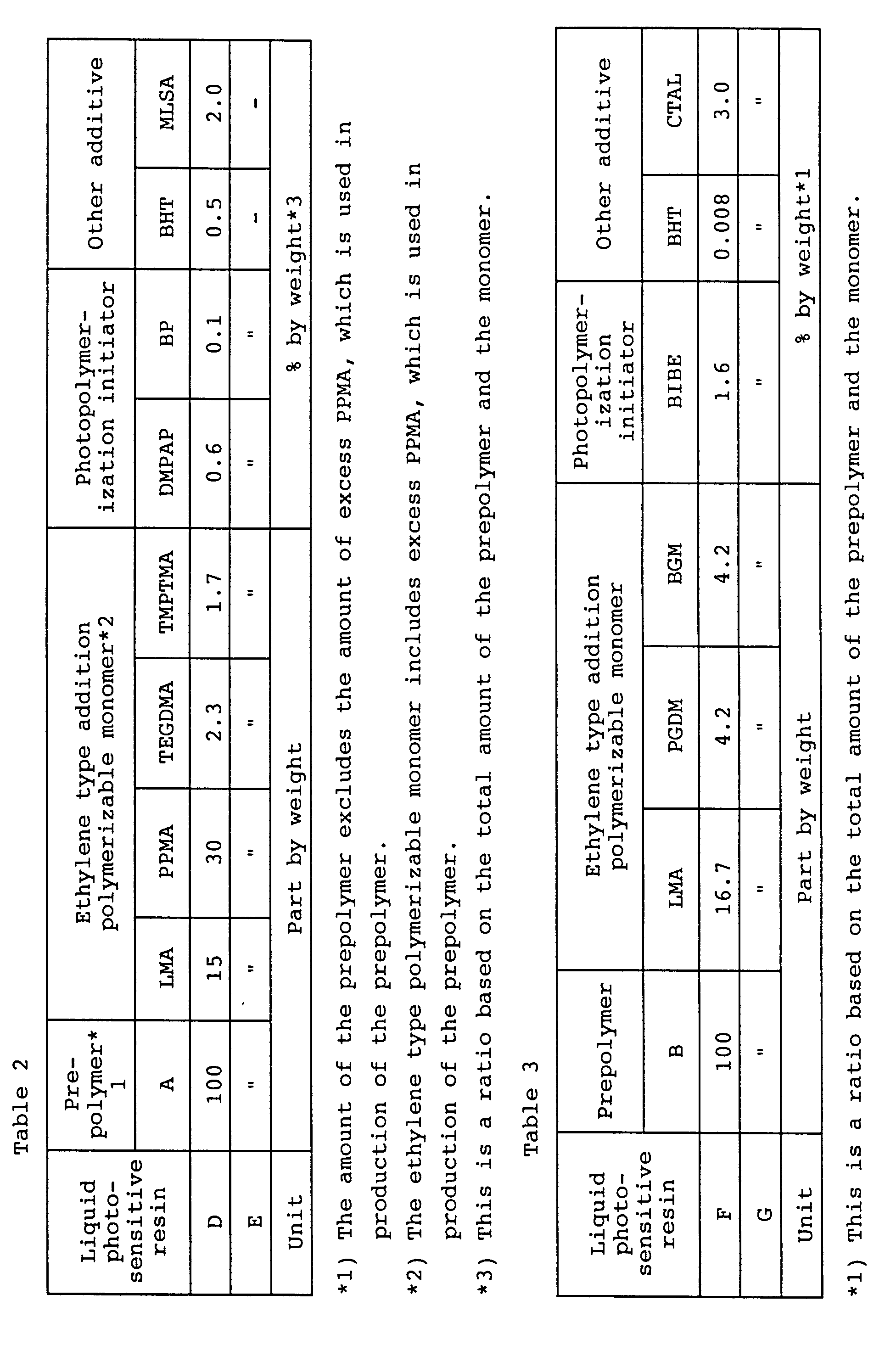

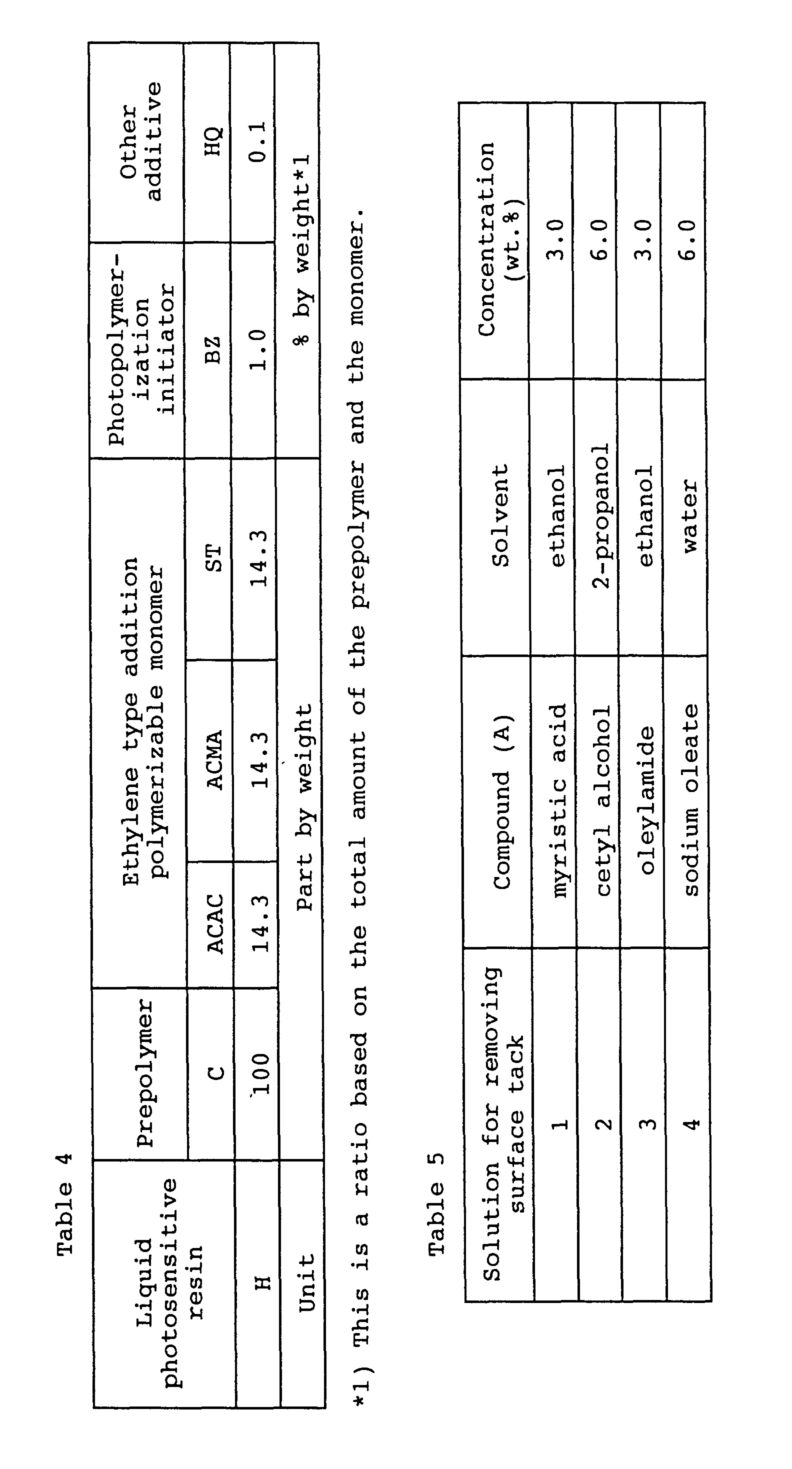

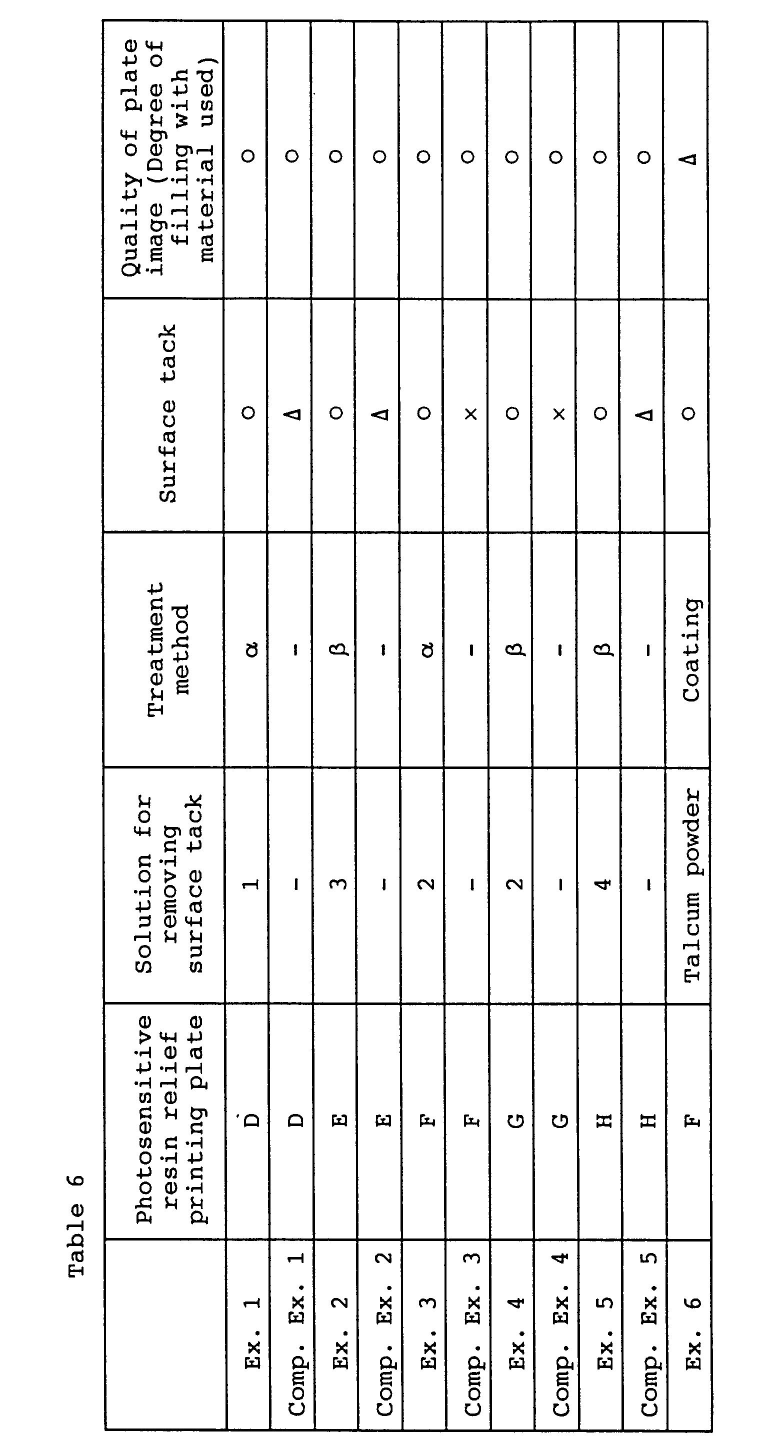

## Claims

1. A method for removing surface tack from a photosensitive resin comprising applying to the surface having tack of a relief printing plate obtained from a liquid photosensitive resin by at least the steps of imagewise exposure, development and post exposure, an aqueous solution or an alcohol solution containing a compound represented by the following general formula (1):
R₁-X (1)
wherein R₁ represents a monovalent hydrocarbon group having the formula CₙH₂ₙ₊₁ or CₙH₂ₙ₋₁ in which n is an integer of 11 or more, and X represents a hydroxyl group, a carboxyl group, an amide derivative or an alkali metal salt derivative of the carboxyl group,
wherein the method is carried out after the post exposure treatment.

2. The method according to claim 1, wherein the application of the aqueous or alcohol solution is carried out by dipping the surface of the relief printing plate into said solution and then taking it out.

3. The method according to claim 1 or 2, wherein the concentration of the compound represented by the general formula (1) is 0.5 to 15 % by wt.

4. The method according to any of the preceding claims, wherein X in the general formula (1) represents a hydroxyl group or a carboxyl group.

5. The method according to any of the preceding claims, wherein n is an integer of from 11 to 30.

6. The method according to any of the preceding claims, wherein the alcohol is methanol, ethanol, 1-propanol or 2-propanol.

7. The method according to any of the preceding claims, wherein the photosensitive resin contains, as a prepolymer, an unsaturated polyurethane, which contains at least one terminal polymerisable ethylenic double bond and a segment of hydrogenated 1,2-polybutadiene.

## Patentansprüche

1. Verfahren zum Entfernen der Oberflächenklebrigkeit von einem lichtempfindlichen Harz, welches das Auftragen einer wässerigen Lösung oder einer Alkohollösung, die eine Verbindung der folgenden allgemeinen Formel (1) enthält:
R₁-X (1)
worin R₁ eine einwertige Kohlenwasserstoffgruppe der Formel CₙH₂ₙ₊₁ oder CₙH₂ₙ₋₁ darstellt, worin n eine ganze Zahl von 11 oder mehr ist, und X eine Hydroxygruppe, Carboxygruppe, ein Amidderivat oder ein Alkalimetallsalzderivat der Carboxygruppe darstellt,
auf die Klebrigkeit aufweisende Oberfläche einer Reliefdruckplatte, erhalten aus einem flüssigen lichtempfindlichen Harz durch mindestens die Stufen der bildweisen Belichtung, Entwicklung und Nachbelichtung, umfasst, wobei das Verfahren nach der Nachbelichtungsbehandlung durchgeführt wird.

2. Verfahren nach Anspruch 1, wobei die Auftragung der wässerigen oder alkoholischen Lösung dadurch durchgeführt wird, dass die Oberfläche der Reliefdruckplatte in die Lösung getaucht und anschließend herausgenommen wird.

3. Verfahren nach Anspruch 1 oder 2, wobei die Konzentration der Verbindung der allgemeinen Formel (1) 0,5 bis 15 Gew.-% ist.

4. Verfahren nach einem der vorstehenden Ansprüche, wobei X in der allgemeinen Formel (1) eine Hydroxygruppe oder Carboxygruppe darstellt.

5. Verfahren nach einem der vorstehenden Ansprüche, wobei n eine ganze Zahl von 11 bis 30 ist.

6. Verfahren nach einem der vorstehenden Ansprüche, wobei der Alkohol Methanol, Ethanol, 1,2-Propanol oder 2-Propanol ist.

7. Verfahren nach einem der vorstehenden Ansprüche, wobei das lichtempfindliche Harz als Prepolymer ein ungesättigtes Polyurethan enthält, das mindestens eine terminale polymerisierbare ethylenische Doppelbindung und ein Segment aus hydriertem 1,2-Polybutadien enthält.

## Revendications

1. Procédé d'élimination de l'adhésivité de surface d'une résine photosensible comprenant le fait d'appliquer sur la surface présentant une adhésivité de surface d'une planche d'impression en relief obtenue à partie d'une résine photosensible liquide, par au moins les étapes d'exposition conformément à une image, de développement et de post-exposition, une solution aqueuse ou une solution alcoolique contenant un composé répondant à la formule générale (1) suivante :
R₁-X (1)
dans laquelle R₁ représente un groupe hydrocarbure monovalent répondant aux formules CₙH₂ₙ₊₁ ou CₙH₂ₙ₋₁ dans lesquelles n est un entier égal ou supérieur à 11, et X représente un groupe hydroxyle, un groupe carboxyle, un dérivé d'amide ou un dérivé de sel de métal alcalin du groupe carboxyle,
dans lequel le procédé est appliqué après le traitement de post-exposition.

2. Procédé selon la revendication 1, dans lequel l'application de la solution aqueuse ou alcoolique est effectuée en plongeant la surface de la planche d'impression en relief dans cette solution et en l'en retirant.

3. Procédé selon les revendications 1 ou 2, dans lequel la concentration du composé répondant à la formule générale (1) est de 0,5 à 15 % en poids.

4. Procédé selon l'une quelconque des revendications précédentes, dans lequel le X de la formule générale (1) représente un groupe hydroxyle ou un groupe carboxyle.

5. Procédé selon l'une quelconque des revendications précédentes, dans lequel n est un entier de 11 à 30.

6. Procédé selon l'une quelconque des revendications précédentes, dans lequel l'alcool est le méthanol, l'éthanol, le 1-propanol ou le 2-propanol.

7. Procédé selon l'une quelconque des revendications précédentes, dans lequel la résine photosensible contient, comme prépolymère, un polyuréthane insaturé qui contient au moins une double liaison éthylénique polymérisable terminale et un segment de 1,2-polybutadiène hydrogéné.
